# EUROPEAN PATENT APPLICATION

(11) **EP 4 422 074 A1**
(43) Date of publication of application: **28.08.2024**
(21) Application number: 23205851.1
(22) Date of filing: 25.10.2023
(51) Int. Cl.: H03K 17/28, B60L 58/10, H02J 7/00, H03K 3/0233, B60L 3/00, H01H 47/00

(54) **SWITCH CONTROL DEVICE AND BATTERY PACK INCLUDING THE SAME**

(30) Priority: 22.02.2023 KR 20230023770
(71) Applicant: Samsung SDI Co., Ltd., Yongin-si, Gyeonggi-do 17084 (KR)
(72) Inventor: CHO, Kyusung, 17084 Yongin-si (KR)
(74) Representative: Marks & Clerk LLP

(57) **Abstract**

A switch control device according to the present disclosure includes: a first retention circuit configured to output a first retention signal to a first driver of a first switch to maintain an on state of the first switch based on a safety signal and a first control signal; a second retention circuit configured to output a second retention signal to a second driver of a second switch to maintain an on state of the second switch based on the safety signal and a second control signal; a retention control circuit configured to control enable of the first and second retention circuit according to the first and second control signals; a first controller configured to output the first control signal and the second control signal; and a second controller configured to output the safety signal according to an operation state of the first controller.

## Description

### BACKGROUND OF THE DISCLOSURE

### (a) Field of the Disclosure

The present disclosure relates to a switch control device and a battery pack including the same.

### (b) Description of the Related Art

Recently, as environmental regulations such as CO₂ regulations have been strengthened, interest in environmentally-friendly vehicles has increased. Accordingly, automobile companies are actively conducting research and product development on pure electric vehicles or hydrogen vehicles as well as hybrid vehicles or plug-in hybrid vehicles.

In environmentally-friendly vehicles, high voltage battery packs are applied to store electrical energy from various energy sources. The high voltage electric system of the vehicle uses the high voltage electrical energy provided from the high voltage battery as the driving or electric energy of the vehicle.

In the battery pack, an output of the battery pack may be transmitted to a load or blocked by a switch such as a relay or contactor. When the switch that transmits the output of the battery pack to the load is turned on due to an error in the control device while the vehicle is driving using the electrical energy of the battery pack, the driving force of the vehicle is lost, and as a result, the vehicle control by a driver falls into a disabled state, thereby causing a safety accident. To solve such a problem, recent battery packs are designed to include a retention circuit that maintain an operation state of a switch in the previous state for a predetermined time in case the control device malfunctions.

A plurality of switches may be connected between the battery pack and the load. In this case, a method of connecting each retention circuit to the switches and allowing each retention circuit to be independently controlled is used. As described, when the retention circuit connected to each switch is independently operated, the retention circuit may malfunction not even in an actual operating condition.

### SUMMARY OF THE DISCLOSURE

A technical object to be solved through the present disclosure is to provide a switch control device for preventing malfunctions in the case of applying a retention circuit to a plurality of switches, and a battery pack including the switch control device.

A switch control device according to an embodiment to solve the above problem includes: a first retention circuit configured to output a first retention signal to a first driver of a first switch to maintain an on state of the first switch based on a safety signal and a first control signal; a second retention circuit configured to output a second retention signal to a second driver of a second switch to maintain an on state of the second switch based on the safety signal and a second control signal; a retention control circuit configured to control enable of the first and second retention circuit according to the first and second control signals; a first controller configured to output the first control signal and the second control signal; and a second controller configured to output the safety signal according to an operation state of the first controller.

The first driver may be configured to control the first switch based on the first control signal or the first retention signal, and the second driver may be configured to control the second switch based on the second control signal or the second retention signal.

The retention control circuit may be configured to enable the first retention circuit and the second retention circuit when the first control signal and the second control signal simultaneously indicate an on state of the first switch and the second switch.

The retention control circuit may include: a latch on circuit configured to output a latch on signal when the first control signal and the second control signal simultaneously indicate the on state of the first switch and the second switch; a latch circuit configured to start outputting a latch signal when the latch on signal is output from the latch on circuit; and an output circuit configured to output a disable signal for disabling the first retention circuit and the second retention circuit to the first retention circuit and the second retention circuit, and to block output of the disable signal when the latch signal is output from the latch circuit.

The first retention circuit and the second retention circuit may be further configured to block the output of the first retention signal and the second retention signal while the disable signal is being received.

The latch on circuit may include: a first transistor that includes a control terminal to which the first control signal is input, a first terminal connected to the latch circuit, and a second terminal; and a second transistor that includes a control terminal to which the second control signal is input, a first terminal connected to the second terminal of the first transistor, and a second terminal connected to the ground. The first transistor may be turned on when the first control signal indicates an on state of the first switch. The second transistor may be turned on when the second control signal indicates an on state of the second switch. The latch on circuit may be further configured to output the latch on signal when both the first transistor and the second transistor are turned on.

The latch circuit may include: a comparator that includes a first input terminal connected to a first node connected to the latch on-circuit, a second input terminal connected to a second node, and an output terminal, and controls outputting of the latch signal according to a voltage comparison result of the first node and the second node; a first voltage distribution circuit that transmits a first voltage distributed from the power source voltage to the first node; a second voltage distribution circuit that transmits a second voltage distributed from the power source voltage to the second node; and a diode that including an anode connected to the output terminal of the comparator and a cathode connected to the second node, and transmits a third voltage to the second node when output of the latch signal starts.

When the latch on signal is output from the latch on circuit, the voltage of the second node may be changed to the voltage of the latch on signal. The second voltage may be lower than the first voltage, the voltage of the latch on signal may be lower than the second voltage, and the third voltage may be higher than the first voltage.

The output circuit may include a diode that controls outputting of the disable signal with respect to the first retention circuit and the second retention circuit according to the latch signal, and may include an anode connected to the first retention circuit and the second retention circuit and a cathode connected to an output terminal of the comparator.

The first controller may be further configured to output a reset signal to the retention control circuit. The retention control circuit may further include a latch off circuit configured to block outputting of the latch signal when the reset signal is received in an enabled state of the first and second retention circuits.

The latch off circuit may include a transistor that includes a control terminal to which the reset signal is input, a first terminal connected to the latch circuit, and a second terminal connected to the ground. When the reset signal is input to the control terminal, the transistor may be turned on and outputs a latch off signal to the latch circuit. The latch circuit may be further configured to turn off a latch function to block the output of the latch signal when the latch off signal is received.

The first retention circuit includes: a first latch circuit configured to receive the first control signal and the safety signal, and to start outputting the first retention signal according to the first control signal when the safety signal indicates an abnormal state of the first controller; and a first timer circuit configured to stop the output of the first retention signal when a predetermined time is elapsed after the first latch circuit starts the output of the first retention signal.

The first latch circuit may be further configured to delay the received first control signal for a predetermined time when the first control signal is received, and to start the output of the first retention signal when the delayed first control signal indicates the on state of the first switch.

The second retention circuit includes: a second latch circuit configured to receive the second control signal and the safety signal, and to start outputting the second retention signal according to the second control signal when the safety signal indicates an abnormal state of the first controller; and a second timer circuit configured to stop the output of the second retention signal when a predetermined time is elapsed after the second latch circuit starts outputting the second retention signal.

The second latch circuit may be further configured to delay the received second control signal for a predetermined time when the second control signal is received, and to start the output of the second retention signal when the delayed second control signal indicates the on state of the second switch.

A battery pack according to an embodiment includes: a battery module; a first switch and a second switch that control an electrical connection between the battery module and a load; a first driver and a second driver configured to control turn on/turn off of the first switch and the second switch; and the switch control device including at least one of the above-stated features. The first driver and the second driver may be further configured to control turn on/turn off of the first switch and the second switch according to a signal transmitted from the switch control device.

At least some of the above and other features of the invention are set out in the claims.

According to the present disclosure, it is possible to prevent malfunctions when applying a retention circuit to each of a plurality of switches.

### BRIEF DESCRIPTION OF THE DRAWINGS

FIG. 1 schematically shows a switch control device according to an embodiment.
FIG. 2 schematically shows a retention circuit according to an embodiment.
FIG. 3A and FIG. 3B are provided for description of a latch operation of the retention circuit of FIG. 2.
FIG. 4 schematically illustrates a retention control circuit according to an embodiment.
FIG. 5 shows an example of a circuit diagram of the retention control circuit according to an embodiment.
FIG. 6 is provided for description of the latch operation of the retention control circuit according to an embodiment.
FIG. 7 schematically illustrates a timing diagram of the switch control device 100 according to an embodiment.
FIG. 8 schematically illustrates a battery pack including a switch control device according to an embodiment.

### DETAILED DESCRIPTION OF THE EMBODIMENTS

Hereinafter, embodiments of the present invention will be described in detail with reference to the accompanying drawings. Effects and features of the embodiments, and implementation methods thereof will be described in detail with reference to the accompanying drawings below. In the drawing, the same reference numeral indicates the same constituent element, and redundant description thereof is omitted. However, the present invention may be embodied in a variety of forms and should not be construed as limited to the embodiments set forth herein. On the contrary, the embodiments are provided as examples such that the present disclosure will be thorough and complete, and will fully convey the aspects and features of the present invention to those skilled in the art.

Accordingly, processes, elements, and techniques that are not deemed necessary to a person of an ordinary skill in the art for a full understanding of aspects and features of the present invention may not be described. In drawings, the relative sizes of elements, layers, and regions may be exaggerated for clarity.

In the present document, the term "and/or" includes all combinations or any combination of the plurality of items listed in relation thereto. When describing embodiments of the present invention, the use of "may" or "could be" means "at least one embodiment of the present invention". Terms in the singular form in the present document may include the plural form unless the context clearly dictates otherwise.

In the present document, terms including ordinal numbers such as "first," "second," "third" and the like are used to describe various components. However, these components are not limited by these terms. These terms are used only to distinguish one component from another component. For example, a 'first' component may be named a `second' component and the `second' component may also be similarly named the 'first' component, without departing from the scope of the present invention.

In the present document, when one component or layer is described as being "on, " "connected to, " or "coupled to" another component or layer, it may be "directly on" another component or layer or "connected to" and "coupled to" another component or layer interposing one or more other components or layers. In addition, when a component or layer is described as being "between" two components or layers, it should be understood as only one component or layer between the two components or layers, or one or more other components or layers interposed between the same.

In the present document, a case where two components are electrically connected to each other may not only include a case where the two components are directly connected to each other, but also include a case where the two components are connected to each other through another component. Another component may include a switch, a resistor, a capacitor or the like. In describing the embodiments, an expression "to connect" may indicate "to electrically connect" when there is no expression "to directly connect.

Hereinafter, a switch control device according to embodiments, and a battery pack including the same will be described in detail with reference to necessary drawings.

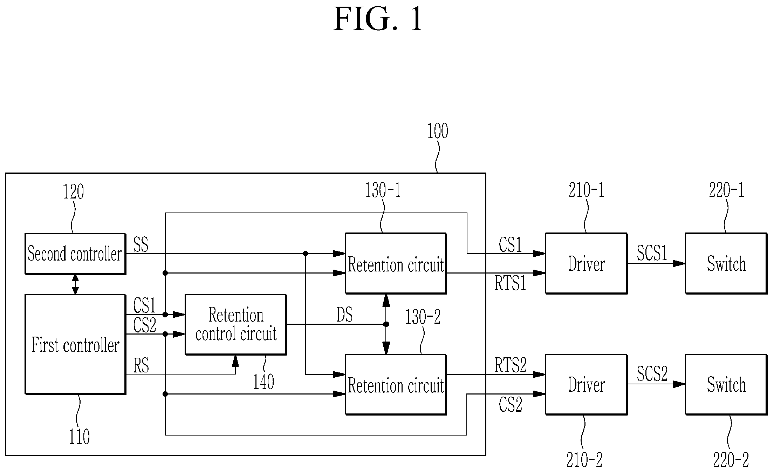

FIG. 1 schematically illustrates a switch control device according to an embodiment.

Referring to FIG. 1, a switch control device 100 may include a first controller 110, a second controller 120, a plurality of retention circuits 130-1 and 130-2, and a retention control circuit 140.

The first controller 110 may determine whether to shut off each of the switches 220-1 and 220-2, and output control signals CS1 and CS2 for controlling each of the switches 220-1 and 220-2. For example, the first controller 110 may output high-level control signals CS1 and CS2 to control the respective switches 220-1 and 220-2 to an on state (i.e., a closed state), and may output low-level control signals CS1 and CS2 to control each of the switches 220-1 and 220-2 in an off state (i.e., an open state). In the present document, the high level of each signal may represent a power source voltage (e.g., 5V) of a first controller 110 or a voltage level close to the power source voltage, and the low level of each signal may represent the ground voltage 0V or a voltage level close to the ground voltage.

When the operation of the retention circuits 130-1 and 130-2 is enabled by the retention control circuit 140, the first controller 110 may output a reset signal RS to disable the operation of the retention circuits 130-1 and 130-2 again. For example, when at least one of the control signals CS1 and CS2 is changed to instruct the off-state of the switches 220-1 and 220-2 after the retention circuits 130-1 and 130-2 both are enabled, the first controller 110 may disable the operation of retention circuits 130-1 and 130-2 again by outputting the reset signal RS before the control signals CS1 and CS2 change again to indicate the on state of switches 220-1 and 220-2.

The second controller 120 may monitor the operation state of the first controller 110. For example, the second controller 120 continuously communicates with the first controller 110, and the operation state of the first controller 110 can be determined from the communication state with the first controller 110. In addition, for example, the second controller 120 periodically receives an error detection signal from the first controller 110 to detect the operation state of the first controller 110, and may determine the operation state of the first controller 110 according to a receiving state of the error detection signal (receiving state, pulse width, reception period, and the like). The second controller 120 may output a safety signal SS indicating an operation state of the first controller 110, that is, whether the operation is normal. For example, the second controller 120 may output a high-level safety signal during normal operation of the first controller 110, and output a low-level safety signal during abnormal operation of the first controller 110.

Each of the retention circuits 130-1 and 130-2 may receive control signals CS1 and CS2 from the first controller 110, respectively. Each of the retention circuits 130-1 and 130-2 may receive a safety signal SS from the second controller 120. Each of the retention circuits 130-1 and 130-2 may generate high-level retention signals RTS1 and RTS2 according to the control signals CS1 and CS2 and the safety signal SS, and output the generated signals to corresponding drivers 210-1 and 210-2. Each of the retention circuits 130-1 and 130-2 may control the output of retention signals RTS1 and RTS2 according to the operation state of the first controller 110 indicated by the safety signal SS.

Each of the retention circuits 130-1 and 130-2 may be configured not to output the retention signals RTS1 and RTS2 when the safety signal SS indicates a normal state of the first controller 110.

When the safety signal SS indicates an abnormal state of the first controller 110, each of the retention circuits 130-1 and 130-2 may output the retention signals RTS1 and RTS2 in response to the control signals CS1 and CS2 output in the normal state of the first controller 110 immediately before.

Each of the retention circuits 130-1 and 130-2 may be configured not to output the retention signals RTS1 and RTS2, when the safety signal SS is changed to indicate an abnormal state while the first controller 110 is outputting low level control signals CS1 and CS2 in a normal state. Each of the retention circuits 130-1 and 130-2 may maintain outputting of the retention signals RTS1 and RTS2, when the safety signal SS is changed to indicate an abnormal state while the first controller 110 is outputting high level control signals CS1 and CS2 in a normal state.

The retention signals RTS1 and RTS2 are high-level output signals, and while not outputting the retention signals RTS1 and RTS2, each of the retention circuits 130-1 and 130-2 may maintain a low-level output.

When the output of retention signals RTS1 and RTS2 starts, each of the retention circuits 130-1 and 130-2 may maintain outputting of retention signals RTS1 and RTS2 for a predetermined time, and end outputting of retention signals RTS1 and RTS2 when the predetermined time elapses. Each of the retention circuits 130-1 and 130-2 may end the outputting of the retention signals RTS1 and RTS2 when the safety signal SS is changed to indicate the normal state of the first controller 110 while outputting the retention signals RTS1 and RTS2.

The retention control circuit 140 may receive control signals CS1 and CS2 corresponding to the switches 220-1 and 220-2 from the first controller 110, respectively. In addition, the retention control circuit 140 may receive a reset signal RS from the first controller 110. The retention control circuit 140 may disable or enable the operation of the retention circuits 130-1 and 130-2 based on these signals received from the first controller 110.

In the default state, the retention control circuit 140 disables the operation of all retention circuits 130-1 and 130-2 by outputting a disable signal DS to each of the retention circuits 130-1 and 130-2. After that, the retention control circuit 140 blocks the outputting of the disable signal DS when the control signals CS1 and CS2 corresponding to each of the switches 220-1 and 220-2 both (e.g. simultaneously) indicate the on-state of the switches 220-1 and 220-2 to enable all the operation of the retention circuits 130-1 and 130-2. When the retention control circuit 140 receives a reset signal RS from the first controller 110 while the operation of the retention circuits 130-1 and 130-2 is enabled, the retention control circuit 140 outputs the disable signal DS to each of the retention circuits 130-1 and 130-2 to disable the operation of all retention circuits 130-1 and 130-2.

When receiving the disable signal DS from the retention control circuit 140, each of the retention circuits 130-1 and 130-2 may block the output of the retention signals RTS1 and RTS2 regardless of the safety signal SS. Each of the retention circuits 130-1 and 130-2 may control the output of the retention signals RTS1 and RTS2 according to the safety signal SS when the output of the disable signal DS from the retention control circuit 140 is stopped.

Each of the drivers 210-1 and 210-2 may receive the control signals CS1 and CS2 and the retention signals RTS1 and RTS2 respectively to control the opening/closing of the switches 220-1 and 220-2 corresponding to the first controller 110 and the retention circuits 130-1 and 130-2. Each of the drivers 210-1 and 210-2 generates switch control signals SCS1 and SCS2 based on the corresponding control signals CS1 and CS2 and retention signals RTS1 and RTS2, and may control the corresponding switches 220-1 and 220-2 (e.g., contactor, relay, and the like) to be on (closed) or off (open). Each of the drivers 210-1 and 210-2 may be a logical OR circuit having the control signals CS1 and CS2 and the retention signals RTS1 and RTS2 as inputs. For example, each of the drivers 210-1 and 210-2 may output the switch control signals SCS1 and SCS2 to control the corresponding switches 220-1 and 220-2 to be in an on state when at least one of the corresponding control signals CS1 and CS2 and the retention signals RTS1 and RTS2 is at a high level. In addition, for example, each of the drivers 210-1 and 210-2 output switch control signals SCS1 and SCS2 to control the corresponding switches 220-1 and 220-2 to be in an off state when the corresponding control signals CS1 and CS2 and the retention signals RTS1 and RTS2 both are at a low level.

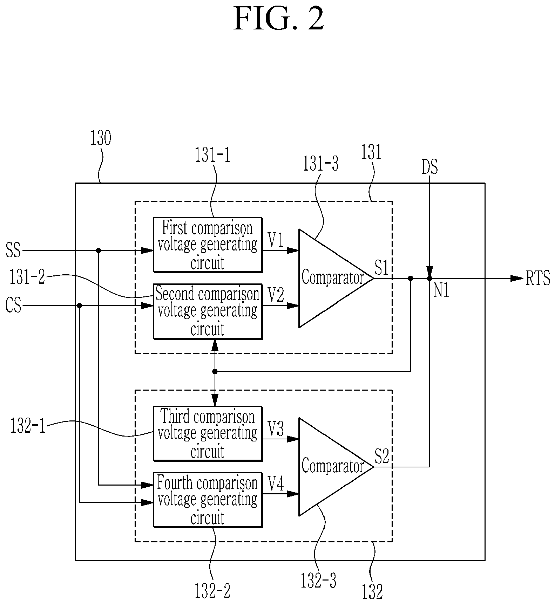

FIG. 2 schematically shows a retention circuit according to an embodiment.

Referring to FIG. 2, a retention circuit 130 according to an embodiment may include a latch circuit 131 and a timer circuit 132.

The latch circuit 131 may receive a control signal CS and a safety signal SS from a first controller 110 and a second controller 120, respectively, and generate a retention signal RTS based on the control signal CS and the safety signal SS. That is, if the first controller 110 operates in an abnormal state while outputting a high-level control signal CS and the a low-level control signal CS and a low-level safety signal SS are input to the latch circuit 131, the latch circuit 131 may generate the retention signal RTS for maintaining the switch 220 in an on state.

The latch circuit 131 may include a comparator 131-3 and comparison voltage generating circuits 131-1 and 131-2 respectively connected to input terminals of the comparator 131-3.

The comparison voltage generating circuit 131-1 may be connected between the second controller 120 and a first input terminal of the comparator 131-3. The comparison voltage generating circuit 131-1 may receive the safety signal SS from the second controller 120 and generate a first comparison voltage V1 according to the level of the received safety signal SS.

The comparison voltage generating circuit 131-1 may control the voltage level of the first comparison voltage V1 to be a first level when the safety signal SS of the voltage level (i.e., low level) indicating an abnormal state of the first controller 110 is input. The comparison voltage generating circuit 131-1 may control the voltage level of the first comparison voltage V1 to be a second level when the safety signal SS of the voltage level (i.e., high level) indicating the normal state of the first controller 110 is input. The second level may have a higher value than the first level.

The comparison voltage generating circuit 131-1 may include a resistor, a capacitor, and a transistor to generate a first comparison voltage V1 based on the safety signal SS.

The comparison voltage generating circuit 131-1 may transmit the generated first comparison voltage V1 to the first input terminal of the comparator 131-3.

The second comparison voltage generation circuit 131-2 may be connected between the first controller 110 and a second input terminal of the comparator 131-3. The second comparison voltage generation circuit 131-2 may receive a control signal CS from the first controller 110 and generate a second comparison voltage V2 according to a voltage level of the received control signal CS.

The second comparison voltage generation circuit 131-2 may control the voltage level of the second comparison voltage V2 to be a third level when the control signal CS of a voltage level (i.e., low level) indicating an off state of the switch 220 is input. The second comparison voltage generation circuit 131-2 may control the voltage level of the second comparison voltage V2 to be a fourth level when the control signal CS of a voltage level (i.e., high level) indicating an on state of the switch 220 is input. The fourth level may have a higher value than the third level. The third level may have a lower value than the first level. The fourth level may have a value lower than the second level and higher than the first level.

When the control signal CS is received, the second comparison voltage generation circuit 131-2 passes the received control signal through a buffer, delays it for a predetermined time, and generates the second comparison voltage V2 using the delayed control signal. Therefore, when the level of the control signal CS is changed, the voltage level of the second comparison voltage V2 may change after a predetermined time after the level of the control signal CS fluctuates.

The second comparison voltage generation circuit 131-2 is connected to an output terminal of the comparator 131-3, and may change the voltage level of the second comparison voltage V2 in response to a signal S1 received from the output terminal of the comparator 131-3. When a low-level signal S1 is input from the output terminal of the comparator 131-3, the second comparison voltage generation circuit 131-2 may determine the voltage level of the second comparison voltage V2 according to the voltage level of the control signal CS as described above. When a high-level signal S1 is input from the output terminal of the comparator 131-3, the second comparison voltage generation circuit 131-2 may change the voltage level of the second comparison voltage V2 to a fifth level regardless of the voltage level of the control signal CS. The fifth level may have a higher value than the fourth level and the second level.

The second comparison voltage generation circuit 131-2 may include a resistor, a capacitor, and a transistor to generate the second comparison voltage V2 according to the control signal CS. In addition, the second comparison voltage generation circuit 131-2 may further include a diode for changing a level of the second comparison voltage V2 according to the signal S1 input from the output terminal of the comparator 131-3.

The second comparison voltage generation circuit 131-2 may transmit the generated second comparison voltage V2 to the second input terminal of the comparator 131-3.

The comparator 131-3 may include a first input terminal connected to the comparison voltage generating circuit 131-1, a second input terminal connected to the second comparison voltage generation circuit 131-2, and an output terminal connected to the output node N1 of the retention circuit 130.

The comparator 131-3 compares the levels of the first comparison voltage V1 and the second comparison voltage V2 generated by the comparison voltage generating circuit 131-1 and the second comparison voltage generation circuit 131-2, and outputs an output signal S1 in response to the comparison result. The comparator 131-3 may output a high-level output signal S1 when the level of the second comparison voltage V2 is higher than the level of the first comparison voltage V1. The comparator 131-3 may output a low-level output signal S1 when the level of the second comparison voltage V2 is lower than or equal to the level of the first comparison voltage V1.

The signal S1 output from the comparator 131-3 may be transmitted to the output node N1 of the retention circuit 130 and output as a retention signal RTS.

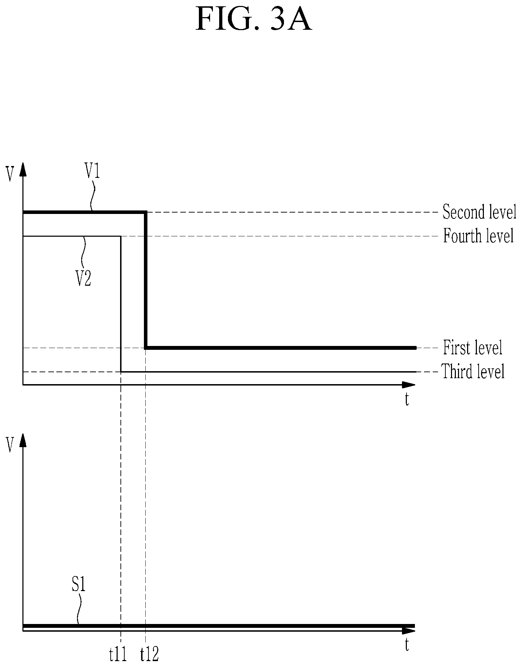

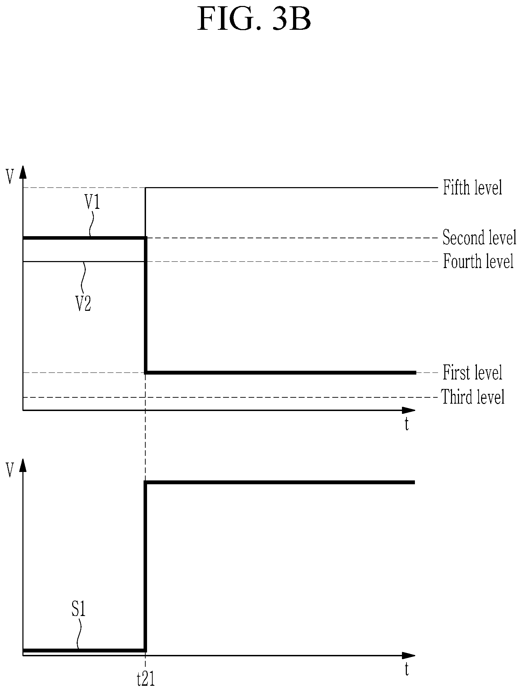

FIG. 3A and FIG. 3B are provided for description of a latch operation of the retention circuit of FIG. 2.

Referring to FIG. 3A, the first controller 110 may change the control signal CS from high level to low level and output it during normal operation. As the control signal CS changes from the high level to the low level, the second comparison voltage generation circuit 131-2 may change the level of the second comparison voltage V2 from the fourth level to the third level at a time t11 and output the same. While the first controller 110 normally operates, the safety signal SS maintains a high level, and the first comparison voltage V1 derived from the safety signal SS maintains a second level. Accordingly, while the first controller 110 normally operates, the output signal S1 of the comparator 131-3 may maintain a low level.

After that, as the first controller 110 operates abnormally, the second controller 120 may change the safety signal SS to low level at a time t12 and output it. As the safety signal SS is changed to the low level, the comparison voltage generating circuit 131-1 may change the level of the first comparison voltage V1 from the second level to the first level and output the same. In this case, since the first level of the first comparison voltage V1 is higher than the third level of the second comparison voltage V2, the output signal S1 output from the comparator 131-3 may maintain a low level.

Referring to FIG. 3B, the first controller 110 maintains the control signal CS at a high level during normal operation and outputs it. While the control signal CS maintains the high level, the second comparison voltage generation circuit 131-2 may output the second comparison voltage V2 of the fourth level. While the first controller 110 normally operates, the safety signal SS maintains a high level, and the first comparison voltage V1 may maintain a second level regardless of the level of the second comparison voltage V2. Therefore, while the first controller 110 outputs normally, the output signal S1 of the comparator 131-3 may maintain a low level.

After that, as the first controller 110 operates abnormally, the first controller 110 and the second controller 120 may change both the control signal CS and the safety signal SS to low level and output them. On the other hand, although the first controller 110 changes the control signal CS to the low level, the second comparison voltage generation circuit 131-2 may maintain the second comparison voltage V2 at the fourth level for a predetermined time and output it. On the other hand, the comparison voltage generating circuit 131-1 may change the level of the first comparison voltage V1 from the second level to the first level at the time t21 as the safety signal SS changes to the low level and output the same. When the level of first comparison voltage V1 is changed to the first level, the second comparison voltage V2 may maintain the fourth level. Since the first level of the first comparison voltage V1 is lower than the fourth level of the second comparison voltage V2, the comparator 131-3 may output a high-level output signal S1 at the time t21.

After that, the high-level output signal S1 is transmitted to the second comparison voltage generation circuit 131-2, and the second comparison voltage generation circuit 131-2 may change the level of the second comparison voltage V2 to the fifth level and output the same. Since the first level of the first comparison voltage V1 is lower than the fifth level of the second comparison voltage V2, the comparator 131-3 may continuously output a high-level output signal S1 thereafter.

As described above, when the first controller 110 is in an abnormal state while the high-level control signal CS is being output, the latch circuit 131 may output a high-level output signal S1. In addition, after the level of the output signal S1 is changed to the high level, the latch function of the latch circuit 131 is enabled such that the latch circuit 131 may continuously output the high-level output signal S1.

Referring back to FIG. 2, the timer circuit 132 may control the time when the retention signal RTS is output. The timer circuit 132 receives the control signal CS and the safety signal SS from the first controller 110 and the second controller 120, respectively, and may generate a timer signal S2 for controlling the time the output of the retention signal RTS based on the control signal CS and safety signal SS.

The timer circuit 132 may include a third comparison voltage generation circuit 132-1, a fourth comparison voltage generation circuit 132-2, and a timer output circuit 132-3.

The third comparison voltage generation circuit 132-1 may be connected between an output terminal of the comparator 131-3 and a first input terminal of the timer output circuit 132-3. The third comparison voltage generation circuit 132-1 may receive the signal S1 from the output terminal of the comparator 131-3 and generate a third comparison voltage V3 in response to the received signal S1. When the high-level signal S1 is output from the output terminal of the comparator 131-3, the third comparison voltage generation circuit 132-1 may output the third comparison voltage V3 of which the voltage level gradually increases in response to the time when the high-level signal S1 is received from the output terminal of the comparator 131-3. That is, the voltage level of the third comparison voltage V3 may gradually increase in response to the time when the high-level signal S1 is received. When the low-level signal S1 is received from the output terminal of the comparator 131-3, the third comparison voltage generation circuit 132-1 gradually reduces the voltage level of the third comparison voltage V3 to a voltage level before the high-level signal S1 is received (e.g. a ground voltage).

The third comparison voltage generation circuit 132-1 may include an RC circuit formed of a resistor and a capacitor to generate a third comparison voltage V3 of which a voltage level is changed according to the output signal S1 of the comparator 131-3.

The fourth comparison voltage generation circuit 132-2 is connected to the first controller 110 and the second controller 120 and may receive the control signal CS and the safety signal SS from the first controller 110 and the second controller 120, respectively. The fourth comparison voltage generation circuit 132-2 is connected to the second input terminal of the timer output circuit 132-3, and may output the fourth comparison voltage V4 generated based on the control signal CS and safety signal SS to the second input terminal of the timer output circuit 132-3.

The fourth comparison voltage generation circuit 132-2 may control a voltage level of the fourth comparison voltage V4 to a sixth level when at least one voltage level of the control signal CS and the safety signal SS is a low level. The fourth comparison voltage generation circuit 132-2 may control the voltage level of the fourth comparison voltage V4 to be a seventh level when both the control signal CS and the safety signal SS are at the high level. The sixth level may be higher than the seventh level. The seventh level may be equal to or lower than the voltage level when resetting the third comparison voltage V3.

The fourth comparison voltage generation circuit 132-2 may include a resistor, a capacitor, and a transistor to generate the fourth comparison voltage V4 of which the voltage level is changed according to the control signal CS and the safety signal SS.

The timer output circuit 132-3 may include a first input terminal connected to the third comparison voltage generation circuit 132-1, a second input terminal connected to the fourth comparison voltage generation circuit 132-2, and an output terminal connected to the output node N1 of the retention circuit 130.

The timer output circuit 132-3 compares the levels of the third comparison voltage V3 and the fourth comparison voltage V4 generated by the third comparison voltage generation circuit 132-1 and the fourth comparison voltage generation circuit 132-2, and receives a timer signal S2 in response to the comparison result. The timer output circuit 132-3 may output a high-level timer signal S2 when the level of the fourth comparison voltage V4 is higher than the level of the third comparison voltage V3. The timer output circuit 132-3 may output a low-level timer signal S2 when the level of the fourth comparison voltage V4 is lower than or equal to the level of the third comparison voltage V3.

When the first controller 110 is in an abnormal state, the fourth comparison voltage generation circuit 132-2 may output a sixth level fourth comparison voltage V4. In addition, when the first controller 110 becomes abnormal and a high-level signal S1 is output from the output terminal of the comparator 131-3, the third comparison voltage generation circuit 132-1 may gradually increase the voltage level of the third comparison voltage V3 and output the third comparison voltage V3. In the beginning when the high-level signal S1 is output, the voltage level of the third comparison voltage V3 may be lower than the sixth level of the fourth comparison voltage V4. Accordingly, the timer output circuit 132-3 may output a high-level timer signal S2. Then, when the output of the high-level signal S1 continues for a predetermined time or longer, the voltage level of the third comparison voltage V3 may increase to the sixth level or higher of the fourth comparison voltage V4. Accordingly, the timer output circuit 132-3 may output a low-level timer signal S2.

On the other hand, when the first controller 110 performs in a normal state while outputting the high-level timer signal S2 and both the control signal CS and the safety signal SS are changed to high level, the fourth comparison voltage generation circuit 132-2 generates the fourth comparison voltage V4 of a seventh level. Regardless of the output of the comparator 131-3, the seventh level of the fourth comparison voltage V4 may be lower than or equal to the voltage level of the third comparison voltage V3. Therefore, the timer output circuit 132-3 may immediately output a low-level timer signal S2 when both the control signal CS and the safety signal SS are changed to high level.

The timer output circuit 132-3 may include a comparator including input terminals to which the third comparison voltage V3 and fourth comparison voltage V4 are input, and an output terminal to which the timer signal S2 is output.

The timer signal S2 output from the timer output circuit 132-3 is transmitted to an output node N1 of the retention circuit 130 to control the output of the retention signal RTS. The high-level signal S1 output from the comparator 131-3 may be output as a retention signal RTS while the level of the timer signal S2 maintains the high level. When the timer signal S2 is changed to the low level, a voltage of the node N1 is changed to the low level by the timer signal S2, and as a result, the output of the retention signal RTS may be stopped. In addition, as the voltage of node N1 is changed to a low level, the latch function of the latch circuit 131 is turned off, and the comparator 131-3 may stop outputting a high-level signal S1.

Meanwhile, a disable signal DS may be applied to the output node N1 of the retention circuit 130 from the retention control circuit 140 described below. The disable signal DS may be a low-level signal. Therefore, while the disable signal DS is applied, the voltage of the node N1 is maintained at a low level, and the output of the retention signal RTS may be blocked. In addition, the latch function of the latch circuit 131 and the timer function of the timer circuit 132 are also turned off, and thus that the maintenance function of the retention circuit 130 may be disabled.

The retention circuit 130 described with reference to FIG. 2, FIG. 3A, and FIG. 3B may be used as the retention circuits 130-1 and 130-2 of FIG. 1. When the retention circuit 130 of FIG. 2 is used as the retention circuit 130-1 of FIG. 1, the control signal CS and the retention signal RTS in the description with reference to FIG. 2, FIG. 3A, and FIG. 3B correspond to the control signal CS1 and the retention signal RTS1 of FIG. 1, respectively. Further, the switch 220 of FIG. 2 corresponds to the switch 220-1 of FIG. 1. When the retention circuit 130 of FIG. 2 is used as the retention circuit 130-2 of FIG. 1, the control signal CS and the retention signal RTS in the description with reference to FIG. 2, FIG. 3A, and FIG. 3B corresponds to the control signal CS2 and the retention signal RTS2 of FIG. 1, respectively. Further, the switch 220 of FIG. 2 corresponds to the switch 220-2 of FIG. 1.

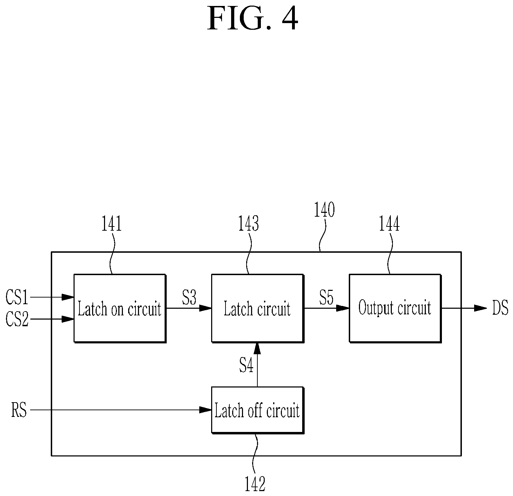

FIG. 4 schematically illustrates a retention control circuit according to an embodiment.

Referring to FIG. 4, a retention control circuit 140 according to an embodiment may include a latch on circuit 141, a latch off circuit 142, a latch circuit 143, and an output circuit 144.

The latch on circuit 141 receives control signals CS1 and CS2 from a first controller 110, and outputs a latch on signal S3 to the latch circuit 143 to turn on the latch function of the latch circuit 143 based on the control signals CS1 and CS2. The latch on circuit 141 may output the latch on signal S3 to the latch circuit 143 when the control signals CS1 and CS2 indicate an on state of the corresponding switches 220-1 and 220-2. The latch on circuit 141 may block the output of the latch on signal S3 when at least one of the control signals CS1 and CS2 indicates an off state of the corresponding switches 220-1 and 220-2.

The latch off circuit 142 operates when a reset signal RS is received from the first controller 110, and may output a latch off signal S4 to the latch circuit 143 to turn off the latch function of the latch circuit 143 during operation.

The latch circuit 143 may turn on the latch function when the latch on signal S3 is received. When the latch function is turned on, the latch circuit 143 may output a latch signal S5 for controlling the output circuit 144 to block outputting of a disable signal DS. When the output of the latch signal S5 is started, the latch circuit 143 may maintain the output of the latch signal S5 until the latch function is turned off by the latch off circuit 142.

When the latch circuit 143 receives the latch off signal S4 while the latch function is on, the latch function may be turned off. When the latch function is turned off, the latch circuit 143 may block the output of the latch signal S5. When the latch function is turned off, the latch circuit 143 may stop outputting the latch signal S5 until the latch function is turned on again according to the latch on circuit 141 thereafter.

The output circuit 144 may block the output of the disable signal DS while the latch signal S5 is output from the latch circuit 143. When receiving of the latch signal S5 is blocked, the output circuit 144 may output the disable signal DS to each of the retention circuits 130-1 and 130-2.

As described above, the retention control circuit 140 outputs the disable signal DS to disable the operation of the retention circuits 130-1 and 130-2 until all control signals CS1 and CS2 output from the first controller 110 indicate the on state of the corresponding switches 220-1 and 220-2, and when all control signals CS1 and CS2 output from the first controller 110 indicate the on state of the corresponding switches 220-1 and 220-2, the retention control circuit 140 stops the outputting of the disable signal DS to allow the operation of all retention circuits 130-1 and 130-2. In addition, even after the operation of the retention circuits 130-1 and 130-2 is permitted, the operations of all the retention circuits 130-1 and 130-2 may be disabled again simply by the first controller 110 outputting a reset signal RS.

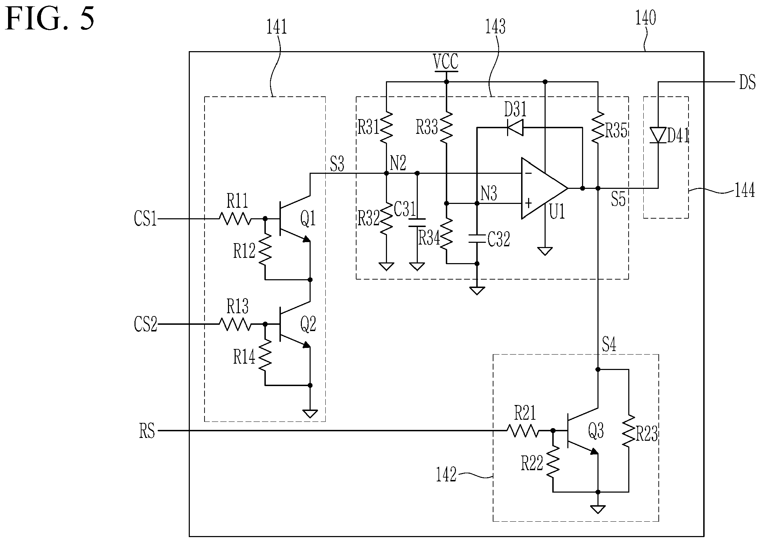

FIG. 5 shows an example of a circuit diagram of the retention control circuit according to an embodiment.

Referring to FIG. 5, the latch on circuit 141 of the retention control circuit 140 according to an embodiment may include two transistors Q1 and Q2.

Transistor Q1 may include a first terminal connected to an output terminal of the latch on circuit 141, a second terminal connected to the transistor Q2, and a control terminal. The control terminal of the transistor Q1 may receive the control signal CS1 from the first controller 110. Transistor Q1 may be turned on when the control signal CS1 indicates the on state of the switch 220-1.

Transistor Q2 may include a first terminal connected to the second terminal of transistor Q1, a second terminal connected to the ground, and a control terminal. A control terminal of the transistor Q2 may receive the control signal CS2 from the first controller 110. Transistor Q2 may be turned on when the control signal CS2 indicates the on state of the switch 220-2.

The transistor Q1 and the transistor Q2 may be NPN transistors in which a control terminal is a base terminal, and a first terminal and a second terminal are a collector terminal and an emitter terminal, respectively. Transistor Q1 may be turned on when a high-level control signal CS1 is input, and turned off when a low-level control signal CS1 is input. The transistor Q2 may be turned on when a high-level control signal CS2 is input, and turned off when a low-level control signal CS2 is input.

The latch on circuit 141 outputs a latch on signal S3 to latch circuit 143 corresponding to the low level when both the transistors Q1 and Q2 are turned on, and may block outputting of the latch on signal S3 when at least one of the two transistors Q1 and Q2 is turned off.

The latch on circuit 141 may further include resistors R11 and R12 electrically connected to the control terminal of the transistor Q1 for stable operation of the transistor Q1. The latch on circuit 141 may further include resistors R13 and R14 electrically connected to the control terminal of the transistor Q1 for stable operation of the transistor Q2.

The latch off circuit 142 may include a transistor Q3.

Transistor Q3 may include a first terminal connected to the output terminal of the latch off circuit 142, a second terminal connected to the ground, and a control terminal. A control terminal of the transistor Q3 may receive a reset signal RS from the first controller 110. The transistor Q3 is turned on when the reset signal RS is received and may output a latch off signal S4 corresponding to a low level to the output terminal of the latch off circuit 142.

The transistor Q3 may be an NPN transistor in which a control terminal is a base terminal, and a first terminal and a second terminal are a collector terminal and an emitter terminal, respectively. The transistor Q3 is turned on when a high-level reset signal RS is input, and may be turned off when the voltage of the control terminal becomes a low level.

For stable operation of the latch off circuit 142, the latch off circuit 142 may further include resistors R21 and R22 electrically connected to the control terminal of the transistor Q3, and a resistor R23 connected between the first terminal of the transistor Q3 and the ground.

The latch circuit 143 may include a comparator U1, a diode D31, and voltage distribution circuits respectively connected to input terminals of the comparator U1.

A first voltage distribution circuit may include a resistor R31 connected between a power supply node VCC and a node N2, and a resistor R32 connected between the node N2 and the ground. The node N2 may be connected to the first input terminal (e.g., negative input terminal) of the comparator U1, and the output terminal of the latch on circuit 141.

The first voltage distribution circuit (hereafter referred to as R31 and R32) may transmit a voltage divided from the power source voltage (e.g., 5V) applied to the power supply node VCC to the first input terminal of the comparator U1, depending on whether the latch on signal S3 is output. In the first voltage distribution circuit R31 and R32, when the latch on signal S3 is not output from the latch on circuit 141, the voltage obtained by dividing the power source voltage applied to the power supply node VCC through the resistors R31 and R32 may be transmitted as a comparison voltage to the first input terminal of the comparator U1. When the low-level latch on signal S3 is output from the latch on circuit 141, the latch on signal S3 may be transmitted as a comparison voltage to the first input terminal of the comparator U1.

The second voltage distribution circuit may include a resistor R33 connected between the power supply node VCC and the node N3, and a resistor R34 connected between the node N3 and the ground. The node N3 may be connected to the second input terminal (e.g., positive input terminal) of the comparator U1, and the diode D31.

The second voltage distribution circuit (hereafter referred to as R33 and R34) may transmit the voltage divided from the power source voltage applied to the power supply node VCC to the second input terminal of the comparator U1 according to the voltage applied to the node N3 through the diode D31. The second voltage distribution circuit R33 and R34 may transmit a voltage divided from the power source voltage applied to the power supply node VCC through the resistors R33 and R34 to the second input terminal of the comparator U1 as a comparison voltage when the voltage transmission through the diode D31 is blocked. When a voltage is applied to the node N3 through the diode D31, the voltage applied to the node N3 through the diode D31 may be transmitted as a comparison voltage to the second input terminal of the comparator U1.

The comparator U1 may include first and second input terminals respectively connected to the nodes N2 and N3, and an output terminal connected to the output terminal of the latch circuit 143. The comparator U1 may compare comparison voltages input through the first and second input terminals and output an output signal to the output terminal in response to the comparison result. The comparator U1 may output a high-level output signal (i.e., latch signal S5) when the comparison voltage input through the second input terminal is higher than the comparison voltage input through the first input terminal. When the comparison voltage input through the second input terminal is lower than or equal to the comparison voltage input through the first input terminal, the comparator U1 stops outputting latch signal S5 and maintains a low-level output.

The comparison voltage transmitted to the second input terminal of the comparator U1 by the second voltage distribution circuit R33 and R34 may be lower than or equal to the comparison voltage transmitted to the first input terminal of the comparator U1 by the first voltage distribution circuit R31 and R32. Therefore, while the latch on signal S3 is not output from the latch on circuit 141, the comparison voltage applied to the second input terminal of the comparator U1 maintains lower than the comparison voltage applied to the first input terminal such that the comparator U1 maintains a low-level output.

When the latch on signal S3 is output from the latch on circuit 141, the comparison voltage transmitted to the first input terminal of comparator U1 may be lower than the comparison voltage transmitted to the second input terminal of comparator U1 by the second voltage distribution circuit R33 and R34. Therefore, while the latch on signal S3 is being output from the latch on circuit 141, the comparison voltage applied to the second input terminal of comparator U1 is higher than the comparison voltage applied to the first input terminal, and thus the comparator U1 may output a high-level signal (i.e., latch signal S5).

The diode D31 may include an anode connected to the output terminal of the comparator U1 and a cathode connected to the second input terminal of the comparator U1. When the high-level latch signal S5 is output from the comparator U1, the diode D31 may transmit the high-level latch signal S5 to the second input terminal of the comparator U1. The voltage transmitted to the second input terminal of the comparator U1 by the diode D31 may be a higher voltage than the voltage applied to the first input terminal of comparator U1 by the first voltage distribution circuit R31 and R32 and the voltage of the latch on signal S3. Therefore, the comparator U1 may maintain the output of the latch signal S5 regardless of whether the latch on signal S3 is output because the latch function is turned on by the diode D31 after the output of the latch signal S5 starts.

Meanwhile, the output terminal of the comparator U1 may be connected to the output terminal of the latch off circuit 142. Accordingly, the latch off signal S4 output from the latch off circuit 142 may be applied to the output terminal of the comparator U1. When the latch off signal S4 is output from the latch off circuit 142, voltage transmission by the diode D31 is blocked, and thus the latch function maintained by the diode D31 may be turned off. As the latch function is turned off, the comparison voltage input to the second input terminal of the comparator U1 is changed to the voltage distributed by the second voltage distribution circuit R33 and R34, and thus output of the latch signal S5 of the comparator U1 may be blocked.

The latch circuit 143 may further include capacitors C31 and C32 connected between each input terminal and the ground, and a resistor R35 connected between the power supply node VCC and the output node of the comparator U1 for stable operation of the comparator U1.

The output circuit 144 may include a diode D41.

The diode D41 may include an anode connected to each of the retention circuits 130-1 and 130-2, and a cathode connected to an output terminal of the latch circuit 143 (i.e., an output terminal of comparator U1). The diode D41 is conductive while the output of latch circuit 143 is maintained at low level, and may transmit a low-level disable signal DS to each of the retention circuits 130-1 and 130-2. When the latch circuit 143 outputs a high-level latch signal S5, the diode D41 becomes non-conductive and may block the output of the disable signal DS.

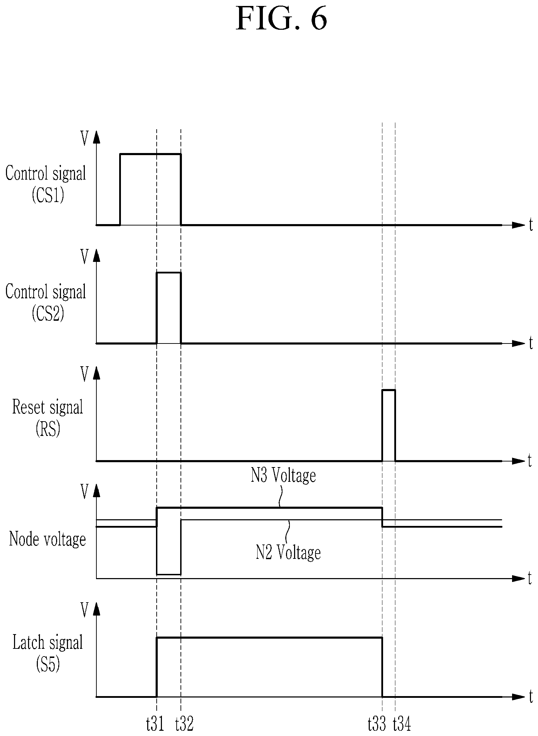

FIG. 6 is provided for description of the latch operation of the retention control circuit according to an embodiment.

Referring to FIG. 6, in a default state, the voltage of each of the nodes N2 and N3 of the latch circuit 143 is determined by the first and second voltage distribution circuits, and the voltage of the node N2 may maintain a state higher than the voltage of the node N3 (section before t31). Therefore, in the default state, the output of the latch circuit 143 may be maintained at a low level.

Then, at the time t31, the control signals CS1 and CS2 output from the first controller 110 all become high level, and accordingly, the latch on signal S3 is output from the latch on circuit 141, and thus the voltage of the node N2 may be lower than the voltage of node N3. Accordingly, the latch circuit 143 may initiate output of a high-level latch signal S5.

As the high-level latch signal S5 is output by the latch circuit 143, the voltage of the node N3 may be increased by the voltage of the latch signal S5. Accordingly, although the control signals CS1 and CS2 are changed to low levels at a time t32 and the voltage of the node N2 increases again, the voltage of the node N3 may still maintain a higher level than the voltage of the node N2. Therefore, although the control signals CS1 and CS2 are changed to low levels, the latch circuit 143 may maintain the output of the high-level latch signal S5. While the output of the latch signal S5 is maintained, the output circuit 144 may stop the output of the disable signal DS, and accordingly, the output of the retention signals RTS1 and RTS2 of the retention circuits 130-1 and 130-2 may be allowed.

At a time t33, the first controller 110 outputs a reset signal RS in the form of a single pulse (for example, lasting from t33 to t34) to disable the retention circuits 130-1 and 130-2 again, and the output of the latch circuit 143 may be changed to low level by the reset signal RS. As the output of the latch circuit 143 changes to the low level, the voltage of the node N3 decreases to a state lower than the voltage of the node N2, and such a state may be maintained even though the output of the reset signal RS is stopped.

As the voltage of the node N3 becomes lower than that of the node N2, the latch circuit 143 may stop outputting the latch signal S5 and maintain the low-level output. When the output of the latch signal S5 is stopped, the disable signal DS is transmitted to each of the retention circuits 130-1 and 130-2 by the output circuit 144, and the output of the retention signals RTS1 and RTS2 of each of the retention circuits 130-1 and 130-2 may be blocked.

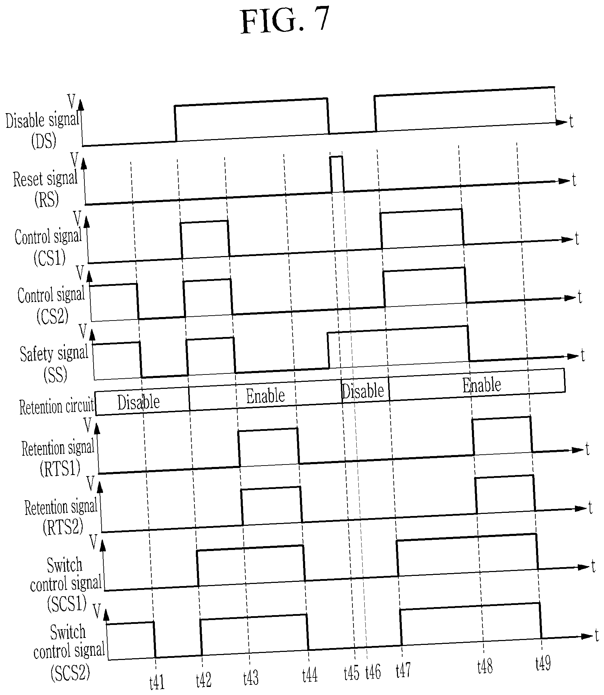

FIG. 7 schematically illustrates a timing diagram of the switch control device 100 according to an embodiment.

Referring to FIG. 7, the retention control circuit 140 outputs the disable signal DS to each of the retention circuits 130-1 and 130-2 in the default state to disable the maintenance function of each of the retention circuits 130-1 and 130-2 (before time t41). When the maintenance function of each of the retention circuits 130-1 and 130-2 is disabled, the output of retention signals RTS1 and RTS2 may be blocked. When the output of the retention signals RTS1 and RTS2 is blocked, each of the drivers 210-1 and 210-2 may be controlled only by the control signals CS1 and CS2 output from the first controller 110 regardless of the safety signal SS. For example, although the first controller 110 operates abnormally and thus a low-level safety signal SS is output from the second controller 120 at the time t41, the driver 210-2 may output a low-level switch control signal SCS2 according to the low-level control signal CS2 output from the first controller 110.

The retention control circuit 140 may maintain the retention function of each of the retention circuits 130-1 and 130-2 in a disabled state until high-level control signals CS1 and CS2 are output from the first controller 110.

After that, at a time of t42, the two control signals CS1 and CS2 output from the first controller 110 both become high level, and the retention control circuit 140 stops the output of the disable signal DS such that the retention function of each of the retention circuits 130-1 and 130-2 may be enabled.

When the retention function is enabled, each of the retention circuits 130-1 and 130-2 may operate to output retention signals RTS1 and RTS2 according to the control signals CS1 and CS2 and the safety signal SS. That is, when the first controller 110 operates abnormally and a low-level safety signal SS is output from the second controller 120 at a time t43, each of the retention circuits 130-1 and 130-2 may output the retention signals RTS1 and RTS2 to maintain the on state of the switches 220-1 and 220-2.

Each of the retention circuits 130-1 and 130-2 maintains the output of the retention signals RTS1 and RTS2 through a latch function when the output of the retention signals RTS1 and RTS2 starts, and controls the retention time of the retention signals RTS1 and RTS2 using a timer function. That is, each of the retention circuits 130-1 and 130-2 uses a timer function to block the output of retention signals RTS1 and RTS2 when the output time of the retention signals RTS1 and RTS2 continues for more than a predetermined time (refer to a time t44).

Then, when the first controller 110 needs to disable the retention function of the retention circuits 130-1 and 130-2, it may output a reset signal RS in the form of a single pulse (see time t45). When the reset signal RS is output from the first controller 110, the retention control circuit 140 outputs the disable signal DS to each of the retention circuits 130-1 and 130-2 to disable the retention function of each of the retention circuits 130-1 and 130-2. The retention control circuit 140 may maintain each of the retention circuits 130-1 and 130-2 in a disabled state even though the output of the reset signal RS is stopped at a time t46.

Then, at a time of t47, when both the control signals CS1 and CS2 output from the first controller 110 become high level, the retention control circuit 140 stops the output of the disable signal DS to each of the retention circuits 130-1 and 130-2 such that the retention function can be enabled.

When the retention function is enabled, each of the retention circuits 130-1 and 130-2 may operate to output the retention signals RTS1 and RTS2 according to the control signals CS1 and CS2 and the safety signal SS. That is, when the first controller 110 operates abnormally and a low-level safety signal SS is output from the second controller 120 at a time t48, each of the retention circuits 130-1 and 130-2 may output the retention signals RTS1 and RTS2 (see t48 and t49) to maintain the on state of the switches 220-1 and 220-2.

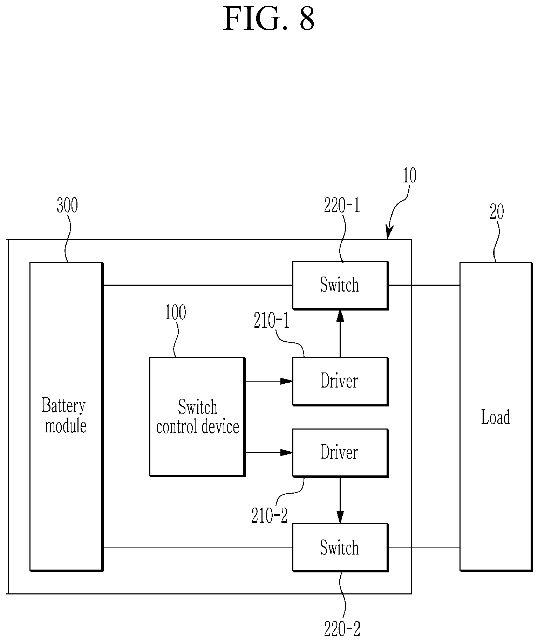

FIG. 8 schematically illustrates a battery pack including a switch control device according to an embodiment.

Referring to FIG. 8, a battery pack 10 may include a battery module 300, a plurality of switches 220-1 and 220-2, a plurality of drivers 210-1 and 210-2, and a switch control device 100.

The battery module 300 may include at least one cell connected in series or in parallel to each other.

Each of the switches 220-1 and 220-2 controls an electrical connection between the battery module 300 and a load 20, and each of the drivers 210-1 and 210-2 may drive corresponding switches 220-1 and 220-2 according to signals (control signals CS1 and CS2 and retention signals RTS1 and RTS2) input from the switch control device 100.

Each of the switches 220-1 and 220-2 may include a contactor, a relay, a transistor, and the like.

As previously described with reference to FIG. 1, the switch control device 100 may include a first controller 110, a second controller 120, a plurality of retention circuits 130-1 and 130-2, and a retention control circuit 140.

The first controller 110 of the switch control device 100 may be a battery management system (BMS) of the battery pack 10. In this case, the first controller 110 may output the control signals CS1 and CS2, a reset signal RS, and the like based on status information of the battery module 300, predetermined information, status information, and driving mode of a system (e.g., vehicle) equipped with the battery pack 10. For example, the first controller 110 determines whether to turn off each of the switches 220-1 and 220-2 according to the battery pack 10 or the state of the system in which the battery pack 10 is mounted, and may output the control signals CS1 and CS2 for controlling the respective switches 220-1 and 220-2. In addition, for example, the first controller 110 may output a reset signal RS to disable the operation of the retention circuits 130-1 and 130-2 before controlling the switches 220-1 and 220-2 to be turned off and turned on again.

The second controller 120 of the switch control device 100 may be a system basis chip (SBC). The SBC may be formed of an integrated circuit (IC) in which a voltage regulator, a supervision function, a reset generator, a watchdog function, a communication bus interface, and a wake-up logic are integrated.

As described above, the switch control device 100 according to an embodiment enables the operation of the retention circuits 130-1 and 130-2 only when all the control signals CS1 and CS2 indicate an on state of the switches 220-1 and 220-2. Accordingly, problems caused by malfunction of the retention circuits 130-1 and 130-2 while at least one of the switches 220-1 and 220-2 are turned off can be solved.

While this invention has been described in connection with what is presently considered to be practical embodiments, it is to be understood that the invention is not limited to the disclosed embodiments. On the contrary, it is intended to cover various modifications and equivalent arrangements included within the scope of the appended claims. Therefore, a person of an ordinary skill in the art will understand that numerous variations and equally other embodiments are possible from this. Therefore, the true technical protection range of the present invention should be determined by the technical ideas of the attached patent claim range.

### <Description of symbols>

10: battery pack
20: load
100: switch control device
110: first controller
120: second controller
130, 130-1, 130-2: retention circuit
131: latch circuit
131-1: first comparison voltage generating circuit
131-2: second comparison voltage generation circuit
131-3: comparator
132: timer circuit
132-1: third comparison voltage generation circuit
132-2: fourth comparison voltage generation circuit
132-3: timer output circuit
140: retention control circuit
141: latch on circuit
142: latch off circuit
143: latch circuit
144: output circuit
210-1, 210-2: driver
220-1, 220-2: switch
300: battery module

## Claims

1. A switch control device comprising:
a first retention circuit configured to output a first retention signal to a first driver of a first switch to maintain an on state of the first switch based on a safety signal and a first control signal;
a second retention circuit configured to output a second retention signal to a second driver of a second switch to maintain an on state of the second switch based on the safety signal and a second control signal;
a retention control circuit configured to control enable of the first and second retention circuits according to the first and second control signals;
a first controller configured to output the first control signal and the second control signal; and
a second controller configured to output the safety signal according to an operation state of the first controller,
wherein the first driver is further configured to control the first switch based on the first control signal or the first retention signal, and the second driver is further configured to control the second switch based on the second control signal or the second retention signal.

2. The switch control device of claim 1, wherein:
the retention control circuit is further configured to enable the first retention circuit and the second retention circuit when the first control signal and the second control signal simultaneously indicate an on state of the first switch and the second switch.

3. The switch control device of claim 2, wherein:
the retention control circuit comprises:
a latch on circuit configured to output a latch on signal when the first control signal and the second control signal simultaneously indicate the on state of the first switch and the second switch;
a latch circuit configured to start outputting a latch signal when the latch on signal is output from the latch on circuit; and
an output circuit configured to output a disable signal for disabling the first retention circuit and the second retention circuit to the first retention circuit and the second retention circuit, and to block output of the disable signal when the latch signal is output from the latch circuit, and
the first retention circuit and the second retention circuit are further configured to block the output of the first retention signal and the second retention signal while the disable signal is being received.

4. The switch control device of claim 3, wherein:
the latch on circuit comprises:
a first transistor that includes a control terminal to which the first control signal is input, a first terminal connected to the latch circuit, and a second terminal; and
a second transistor that includes a control terminal to which the second control signal is input, a first terminal connected to the second terminal of the first transistor, and a second terminal connected to the ground,
the first transistor configured to be turned on when the first control signal indicates an on state of the first switch,
the second transistor configured to be turned on when the second control signal indicates an on state of the second switch, and
the latch on circuit is further configured to output the latch on signal when both the first transistor and the second transistor are turned on.

5. The switch control device of claim 4, wherein:
the latch circuit comprises:
a comparator that includes a first input terminal connected to a first node connected to the latch on-circuit, a second input terminal connected to a second node, and an output terminal, and is configured to control outputting of the latch signal according to a voltage comparison result of the first node and the second node;
a first voltage distribution circuit configured to transmit a first voltage distributed from a power source voltage to the first node;
a second voltage distribution circuit configured to transmit a second voltage distributed from the power source voltage to the second node; and
a diode that includes an anode connected to the output terminal of the comparator and a cathode connected to the second node, and is configured to transmit a third voltage to the second node when output of the latch signal starts.

6. The switch control device of claim 5, configured such that:
when the latch on signal is output from the latch on circuit, the voltage of the second node is changed to the voltage of the latch on signal,
the second voltage is lower than the first voltage, the voltage of the latch on signal is lower than the second voltage, and the third voltage is higher than the first voltage.

7. The switch control device of claim 5, wherein:
the output circuit comprises a diode configured to control outputting of the disable signal with respect to the first retention circuit and the second retention circuit according to the latch signal, and includes an anode connected to the first retention circuit and the second retention circuit and a cathode connected to an output terminal of the comparator.

8. The switch control device of any of claims 3 to 7, wherein:
the first controller is further configured to output a reset signal to the retention control circuit, and
the retention control circuit further comprises a latch off circuit configured to block outputting of the latch signal when the reset signal is received in an enabled state of the first and second retention circuits.

9. The switch control device of claim 8, wherein:
the latch off circuit comprises a transistor that includes a control terminal to which the reset signal is input, a first terminal connected to the latch circuit, and a second terminal connected to the ground,
when the reset signal is input to the control terminal, the transistor is configured to be turned on and to output a latch off signal to the latch circuit, and
the latch circuit is further configured to turn off a latch function to block the output of the latch signal when the latch off signal is received.

10. The switch control device of any preceding claim, wherein:
the first retention circuit comprises:
a first latch circuit configured to receive the first control signal and the safety signal, and to start outputting the first retention signal according to the first control signal when the safety signal indicates an abnormal state of the first controller; and
a first timer circuit configured to stop the output of the first retention signal when a predetermined time is elapsed after the first latch circuit starts the output of the first retention signal.

11. The switch control device of claim 10, wherein:
the first latch circuit is further configured to delay the received first control signal for a predetermined time when the first control signal is received, and to start the output of the first retention signal when the delayed first control signal indicates the on state of the first switch.

12. The switch control device of any preceding claim, wherein:
the second retention circuit comprises:
a second latch circuit configured to receive the second control signal and the safety signal, and to start outputting the second retention signal according to the second control signal when the safety signal indicates an abnormal state of the first controller; and
a second timer circuit configured to stop the output of the second retention signal when a predetermined time is elapsed after the second latch circuit starts outputting the second retention signal.

13. The switch control device of claim 12, wherein:
the second latch circuit is further configured to delay the received second control signal for a predetermined time when the second control signal is received, and to start the output of the second retention signal when the delayed second control signal indicates the on state of the second switch.

14. A battery pack comprising:
a battery module;
a first switch and a second switch configured to control an electrical connection between the battery module and a load;
a first driver and a second driver configured to control turn on/turn off of the first switch and the second switch; and
the switch control device of any one of claim 1 to claim 13,
wherein the first driver and the second driver are further configured to control turn on/turn off of the first switch and the second switch according to a signal transmitted from the switch control device.
